(19) Europäisches Patentamt

European Patent Office

Office européen des brevets

(11) **EP 0 577 589 B1**

(12) **EUROPÄISCHE PATENTSCHRIFT**

(45) Veröffentlichungstag und Bekanntmachung des
Hinweises auf die Patenterteilung:
**12.03.1997 Patentblatt 1997/11**

(51) Int. Cl.$^6$: **B23K 1/005**, B23K 26/04

(21) Anmeldenummer: **93890133.7**

(22) Anmeldetag: **02.07.1993**

(54) **Verfahren zum Löten und Vorrichtung zur Durchführung dieses Verfahrens**

Procedure for soldering and device for the working of this procedure

Procédé pour le soudobrasage et dispositif pour la mise en oeuvre de ce procédé

(84) Benannte Vertragsstaaten:
**AT CH DE FR GB IT LI**

(30) Priorität: **03.07.1992 AT 1363/92**

(43) Veröffentlichungstag der Anmeldung:
**05.01.1994 Patentblatt 1994/01**

(73) Patentinhaber: **ALS APPLIKATIONEN FÜR
LASERSYSTEME GmbH
A-1200 Wien (AT)**

(72) Erfinder:
• **Nicolics, Johann
A-1040 Wien (AT)**

• **Musiejovsky, Laszlo
A-1110 Wien (AT)**

(74) Vertreter: **Weinzinger, Arnulf, Dipl.-Ing. et al
Patentanwälte
Sonn, Pawloy, Weinzinger & Wolfram
Riemergasse 14
1010 Wien (AT)**

(56) Entgegenhaltungen:
**EP-B- 0 257 076**

• **ELECTRONIC DESIGN Bd. 34, Nr. 22, September
1986, HASBROUCK HEIGHTS, NEW JERSEY,
USA Seiten 29 - 30 DIANE TUNICK 'Laser-
soldering system closes inspection loop'**

## Beschreibung

Die Erfindung betrifft ein Verfahren zum Löten, bei dem ein auf wenigstens einem Werkstück vorhandenes Lot mittels eines Laserstrahls erhitzt und die von der Lötstelle abgegebene Wärmestrahlung erfaßt wird, um die Erhitzung mittels des Laserstrahls nach dem Aufschmelzen des Lots zu beenden.

Weiters bezieht sich die Erfindung auch auf eine Vorrichtung zur Durchführung des erfindungsgemäßen Verfahrens, mit einer Lasereinrichtung zur Abgabe eines Laserstrahls, der auf eine Lötstelle gerichtet wird, mit einem Infrarot-Detektor, dem die von der Lötstelle abgegebene Wärmestrahlung zugeführt wird, und mit einer an den Infrarot-Detektor angeschlossenen Steuereinheit, die die Lasereinrichtung abhängig vom Infrarot-Meßsignal des Infrarot-Detektors sowie Relativbewegungen zwischen Werkstück und Laserstrahl steuert.

Aus der EP-B1-257 076 sind ein Verfahren zum Mikrolöten sowie eine Vorrichtung hierfür bekannt, wobei das Lot mit Hilfe eines Laserstrahls erhitzt und geschmolzen wird. Nach Erreichen des Schmelzpunktes des Lots, welcher mit Hilfe eines Infrarot-Detektors erfaßt werden soll, wird der Erhitzungsvorgang nach einer einstellbaren Verzögerungszeit beendet, wobei angestrebt wird, auf diese Weise das Lot über den Schmelzpunkt hinaus definierbar weiter zu erhitzen, um eine ausreichende Benetzung der zu verlötenden Teile mit dem Lot zu ermöglichen. Zur Erfassung des Schmelzens des Lots soll dabei eine Abflachung in der IR-Emissionskurve genutzt werden, die angeblich während des Schmelzens des Lots bis zu dessen vollständiger Verflüssigung auftritt. Tatsächlich hat sich jedoch gezeigt, daß eine derartige Abflachung oder Treppe im Verlauf der IR-Emission des Lots nur in bestimmten Fällen festzustellen ist, nämlich bei relativ langen Lötzeiten und bei Verwendung von bestimmten Lot-Typen; nicht zulässig ist eine derartige Annahme einer Abflachung in der Temperaturkurve während des Aufschmelzvorganges vor allem bei kurzen Lötzeiten, wie sie mit Lasern einer höheren Leistung erzielt werden können, und beispielsweise auch nicht bei Lotlegierungen mit Schmelzintervall - in diesen Fällen ist zu dem Zeitpunkt, zu dem das Lot geschmolzen wird, praktisch keine Unstetigkeit im Verlauf der Kurve der Wärmeabstrahlung der Lötstelle (d.h. keine plötzliche Änderung in der Steigung) festzustellen, so daß die bekannte Technologie vor allem bei schnellen Lötprozessen versagt. Ein weiterer Nachteil des bekannten Verfahrens zum Mikrolöten ist, daß mit der eingestellten Verzögerungszeit nur in ungenügendem Maß ein zufriedenstellender Benetzungsvorgang sichergestellt werden kann.

Es ist daher Ziel der Erfindung, eine Technik zum Laserlöten zur Verfügung zu stellen, bei der der Lötprozeß auf eine Benetzung der zu verlötenden Teile hin überwacht wird, so daß eine wesentlich höhere Lötqualität im Vergleich zu bisher erzielt werden kann. Die Erfindung beruht dabei auf der Erkenntnis, auf Basis von umfangreichen Untersuchungen, daß auch bei schnellen Lötprozessen, in der Größenordnung von insgesamt z.B. nur 100 Millisekunden oder sogar nur 10 Millisekunden (bei kleineren Lötstellen),, im Infrarot-Emissionsverlauf eine signifikante Änderung in der Steigung der Kurve feststellbar ist, wobei diese Änderung, wie nachstehend noch ausführlich erläutert werden wird, aber darauf zurückzuführen ist, daß bei Beginn des Benetzungsvorganges eine erhöhte Wärmeableitung über die zu verlötenden Teile erfolgt, so daß das Lot selbst, trotz kontinuierlich fortgesetzter Wärmezufuhr mittels des Laserstrahls, relativ weniger Wärmeabstrahlung zuläßt, d.h. es ist ein Knick in der IR-Emissionskurve festzustellen, der den Beginn des Benetzungsvorganges anzeigt, wobei ab diesem Knick die IR-Emissionskurve nur mehr vergleichsweise wenig ansteigt oder aber sogar abfällt.

Demgemäß ist das erfindungsgemäße Verfahren der eingangs angeführten Art dadurch gekennzeichnet, daß die erfaßte Wärmestrahlung auf eine nach dem Aufschmelzen des Lots auftretende, eine Benetzung der zu lötenden Teile repräsentierende Unstetigkeit im Anstieg überwacht und erst nach der so erfolgten Feststellung der Benetzung die Erhitzung mittels des Laserstrahls beendet wird.

In entsprechender Weise ist die erfindungsgemäße Vorrichtung dadurch gekennzeichnet, daß die Steuereinheit eine Detektionseinheit zur Erkennung einer eine Benetzung der zu lötenden Teile repräsentierende Unstetigkeit im Anstieg des Infrarot-Meßsignals enthält.

Bei der erfindungsgemäßen Technik erfolgt somit eine Überwachung dahingehend, ob im Kurvenverlauf der Wärmestrahlung von der Lötstelle eine Unstetigkeit oder Änderung im Anstieg auftritt, die eine beginnende Benetzung der zu lötenden Teile anzeigt. Diese Änderung im Anstieg der Kurve ist dabei nicht nur mit größerer Sicherheit und Genauigkeit zu erfassen als der Punkt des Aufschmelzens des Lots, wie beim Stand der Technik, und zwar insbesondere bei schnellen Lötvorgängen, sondern darüber hinaus auch insofern für die Prozeßüberwachung günstiger, als von diesem Punkt der beginnenden Benetzung weg selbstverständlich genauer, aufgrund von Erfahrungswerten bei dem jeweiligen Lot bzw. den jeweiligen Bauteilen, auf den Zeitpunkt der vollständigen Benetzung geschlossen werden kann, wobei zu diesem Zeitpunkt, zu dem die vollständige Benetzung vorausgesetzt werden kann, der Erhitzungsvorgang beendet wird. Würde die Erhitzung mit Hilfe des Laserstrahls zu lange fortgesetzt werden, so würden möglicherweise die zu lötenden Bauteile beschädigt werden, wogegen bei einer zu früh beendeten Wärmezufuhr, bevor eine ausreichende Benetzung stattgefunden hat, eine ungenügende Lötverbindung die Folge ist.

Wie erwähnt steigt die IR-Emission, d.h. Wärmeabstrahlung, während des Benetzungsvorganges weniger stark an, verglichen mit dem Verlauf während des Erhitzungsvorganges bis zum Beginn des Benetzens, und die oben erwähnte Unstetigkeit im Anstieg wird somit zweckmäßigerweise dadurch erfaßt, daß ein der erfaßten Wärmestrahlung entsprechendes Infrarot-Meßsignal auf eine andauernde verminderte Steigung im zeitlichen Signalverlauf überwacht wird. Ob eine andauernde Verminderung in der Steigung vorliegt, kann dabei vorteilhafterweise dadurch realisiert werden, daß das Infrarot-Meßsignal nach der Zeit differenziert und der Pegel der so erhaltenen ersten Ableitung des Infrarot-Meßsignals mit einem vorherbestimmten Schwellenwert verglichen wird.

In der Praxis sind die Steigungen der IR-Meßsignale, z.B. abhängig von Bauteiltoleranzen, Streuungen unterworfen, und demgemäß könnte ein absoluter Schwellenwert oder Vergleichspegel dazu führen, daß eine beginnende Benetzung beispielsweise zu spät oder gar nicht erkannt wird (oder aber eine Benetzung angenommen wird, wenn sie tatsächlich noch nicht begonnen hat). Um dies zu verhindern, ist es daher besonders vorteilhaft, wenn der Schwellenwert als relativer Vergleichspegel, bezogen auf den Maximal-Pegel der ersten Ableitung des Infrarot-Meßsignals vor dem Zeitpunkt des Auftretens der verminderten Steigung, bestimmt wird. Dabei haben praktische Versuche es als besonders günstig erwiesen, wenn der Vergleichspegel bei 80% des Maximalpegels festgelegt wird.

Um die durch eine beginnende Benetzung bewirkte verminderte Steigung von einem etwaigen kurzen Einbruch im IR-Signal-Anstieg unterscheiden zu können (letzteres könnte bei vergleichsweise langsameren Lötvorgängen während des Aufschmelzens des Lotes durch die Schmelzwärme passieren), ist es vorteilhaft, wenn zur Feststellung einer eine Benetzung anzeigenden andauernden verminderten Steigung überwacht wird, ob die Dauer der Meßsignals mit verminderter Steigung ein vorherbestimmtes Zeitintervall überschreitet. Wird das vorgegebene Zeitintervall überschritten, so wird erkannt, daß ein Benetzungsvorgang im Gange ist. Steigt jedoch das Meßsignal vor Erreichen des Endes dieses vorherbestimmten Zeitintervalls wieder stärker an, so lag offensichtlich nur ein kurzer Einbruch im Signal vor, und das Signal muß weiter auf eine beginnende Benetzung wie vorstehend angegeben überwacht werden.

Die Wärmezufuhr durch den Laserstrahl wird nicht sofort mit dem Erkennen eines Benetzungsvorganges abgeschaltet, vielmehr ist noch eine andauernde Wärmezufuhr notwendig, um eine ausreichende Benetzung sicherzustellen, und zu diesem Zweck ist es günstig, wenn das Infrarot-Meßsignal nach Feststellen einer andauernden verminderten Steigung auf eine Erhöhung des Signalpegels um einen vorherbestimmten Betrag gegenüber dem Pegel zu Beginn der verminderten Steigung überwacht und erst dann der Erhitzungsvorgang beendet wird. Die Pegelerhöhung hängt dabei von der jeweiligen Laserleistung und/oder von den zu lötenden Bauteilen und dem verwendeten Lot ab. Für gängige Nd-YAG-Laser und gängige Lottypen sowie herkömmliche elektronische Bauteile, die an Leiterplatinen mit Leiterbahnen angelötet werden, hat es sich beispielsweise als zweckmäßig erwiesen, wenn auf eine Erhöhung des Pegels des Infrarot-Meßsignals um ungefähr 30% überwacht wird.

Von Vorteil ist es hier weiters, wenn die Zeit bis zum Erreichen des erhöhten Signalpegels gemessen und zur Beurteilung der Lötstellenqualität mit vorgegebenen Zeitintervallwerten verglichen wird. Das Bewertungsergebnis (einwandfreie Lötstelle oder Lötstelle mit fraglicher Qualität) kann jeweils abgespeichert werden.

Andererseits ist es zur Festlegung des Zeitpunktes, zu dem eine ausreichende Benetzung angenommen werden kann, auch vorteilhaft, wenn nach Feststellen einer andauernden verminderten Steigung der Erhitzungsvorgang ein vorherbestimmtes Zeitintervall fortgesetzt wird, bevor er beendet wird. Das vorherbestimmte Zeitintervall kann dabei ebenso wie die vorstehend angegebene Pegeldifferenz empirisch aufgrund von einfachen Versuchen, erhalten werden, und es kann für die jeweiligen Materialien und Bauteile eine Parameterbibliothek angelegt werden.

Auch im letzteren Fall ist es weiters von Vorteil, wenn die Erhöhung des Signalpegels des Infrarot-Meßsignals am Ende des vorherbestimmten Zeitintervalls gegenüber dem Pegel am Beginn der andauernden verminderten Steigung gemessen und zur Beurteilung der Lötstellenqualität mit vorgegebenen Pegeldifferenzwerten verglichen wird.

Um eine Lötstellen-spezifische Erkennung der Benetzung zu ermöglichen, ist es bei der erfindungsgemäßen Vorrichtung von besonderem Vorteil, wenn die Detektionseinheit zwischen verschiedenen Erkennungs-Betriebsarten, entsprechend verschiedenen Lötstellen, umschaltbar ist. Dabei ist es insbesondere denkbar, für die verschiedenen Erkennungs-Betriebsarten jeweils eigene Signalaufbereitungs- und Auswerteinheiten vorzusehen, zwischen denen, entweder händisch oder aber bevorzugt durch ein Steuerprogramm, je nach der vorliegenden Lötstelle umgeschaltet wird. Auf diese Weise können bei der Signalerkennung besonders hohe Geschwindigkeiten erzielt werden.

Für eine einfache und rasche Signalerkennung und -auswertung hat es sich weiters als vorteilhaft erwiesen, wenn die Detektionseinheit zumindest eine Differenziereinheit mit nachgeschalteter Vergleichseinheit zum Differenzieren des IR-Meßsignals und Vergleichen des Pegels des differenzierten Signals mit einem Vergleichspegel aufweist.

Zur Abschätzung der ausreichenden Benetzung kann vorgesehen werden, daß die Steuereinheit einen von der Detektionseinheit aktivierbaren Zähler zur Messung von Zeitintervallen ab Beginn einer erkannten Unstetigkeit im Anstieg des IR-Meßsignals aufweist.

Wie bereits vorstehend erwähnt stellt die vorliegende Erfindung insbesondere auf rasche Lötprozesse ab, wie sie vor allem für eine industrielle Fertigung mit Vorteil anzuwenden sein werden, wobei pro Lötstelle Lötzeiten beispielsweise in der Größenordnung von 100 Millisekunden erzielbar sind. Um dabei einen besonderen Vorteil aus der erfindungsgemäßen Technologie ziehen zu können, ist es selbstverständlich auch notwendig, die Zeit für den Übergang von einer Lötstelle zur anderen so kurz wie möglich zu halten. Bei den bekannten Laserlöttechniken wird ein üblicher XY-Werktisch verwendet, der mit Hilfe einer Rechnersteuerung, in die die jeweiligen Koordinaten der Lötstellen eingegeben wurden, in X- und Y-Richtung weiterbewegt wird, um die nächste Lötstelle in Ausrichtung zum Laserstrahl zu bringen. Es müssen somit relativ große Massen bewegt werden, und demgemäß vergehen relativ lange Zeitintervalle zwischen den einzelnen Lötvorgängen, abgesehen davon, daß ein relativ hoher Aufwand für die Einrichtung zum Antreiben des XY-Werktisches notwendig ist. Um nun besonders kurze Intervallzeiten zwischen den einzelnen Lötvorgängen zu erreichen, sieht eine besonders vorteilhafte Ausführungsform der erfindungsgemäßen Vorrichtung vor, daß an die Steuereinheit eine Galvospiegelsteuerung mit X- und Y-Galvospiegel im Strahlengang des Laserstrahls angeschlossen ist, um den Laserstrahl gesteuert zu den verschiedenen Lötstellen am stationären Werkstück zu positionieren. Derartige Galvospiegelanordnungen sind dabei an sich bekannt, etwa von Beschriftungssystemen mit Laserstrahl, aber auch beispielsweise von Compact-Disc-Plattenspielern, und sie ermöglichen eine außerordentlich kurzzeitige Umsteuerung des Laserstrahls, um ihn auf die nächste Lötstelle zu richten.

Für einen optimalen Wärmeeintrag ist zweckmäßigerweise der Laserstrahl im rechten Winkel auf die Lötstelle gerichtet, und in entsprechender Weise wäre es zweckmäßig, die im rechten Winkel von der Lötstelle abgestrahlte Wärmestrahlung für die gewünschten Erkennungsvorgänge zu erfassen. Demgemäß ist es von besonderem Vorteil, wenn die abgegebene Wärmestrahlung über den X- und Y-Galvospiegel und einen IR-Auskoppelspiegel zum Auskoppeln der Wärmestrahlung aus dem Strahlengang des Laserstrahls sowie über ein Filterelement zum IR-Detektor gerichtet wird. Bei dieser Anordnung wird für die Auswertung somit jene Wärmestrahlung erfaßt, die antiparallel zu Laserstrahl im Strahlengang des letzteren zurückverläuft und schließlich aus dem Laser-Strahlengang ausgekoppelt wird. Dabei ist aus Sicherheitsgründen, um den Infrarot-Detektor gegen Laserstrahlung zu schützen, ein Filterelement vorgesehen, das nur die Infrarotstrahlung durchläßt. Das Filterelement kann dabei beispielsweise, um gesonderte Bauteile einzusparen, unmittelbar durch eine für die Fokussierung der Wärmestrahlung eingesetzte Linse gebildet sein, wobei diese Linse dann vorzugsweise eine Germaniumlinse ist.

Zum Auskoppeln der Wärmestrahlung kann einfach vorgesehen werden, daß der IR-Auskoppelspiegel ein Lochspiegel ist, der mit seiner das den Laserstrahl durchlassenden Loch umgebenden Spiegelfläche die Wärmestrahlung reflektiert.

Wie erwähnt sind zwischen den einzelnen Lötvorgängen bei der erfindungsgemäßen Technik bevorzugt extrem kurze Zeiten erreichbar, und in diesen kurzen Zeiten wird vorteilhafterweise die Lasereinrichtung selbst nicht abgeschaltet, sondern nur eine Abschirmung des Laserstrahls vorgenommen, wobei diese Zeiten mit Vorteil auch dazu benutzt werden, die Leistung des Laserstrahls laufend zu überprüfen. Demgemäß ist es ferner vorteilhaft, wenn die Steuereinheit mit einem der Lasereinrichtung zugeordneten Spiegelshutter im Strahlengang des Laserstrahls verbunden ist, um diesen während der Positionier-Betätigung der X- und Y-Galvospiegels abzuschirmen, wobei es weiters günstig ist, wenn der Spiegelshutter den Laserstrahl während der Positionier-Betätigung des X- und Y-Galvospiegels zu einem Laserleistungsmesser ablenkt.

Die Erfindung wird nachstehend anhand von bevorzugten Ausführungsbeispielen unter Bezugnahme auf die Zeichnung noch weiter erläutert. In der Zeichnung zeigen im einzelnen:

Fig.1 eine schematische Darstellung einer Lötstelle vor Beginn des Lötvorganges;

Fig.2 einen Querschnitt durch eine derartige Lötstelle im Bereich der zu lötenden Elemente, wobei das Lot bereits aufgeschmolzen wurde, jedoch noch kein Zusammenfließen erfolgt ist;

Fig.3 in gegenüber Fig.2 vergrößertem Maßstab einen entsprechenden Querschnitt in dem Stadium, in dem eine Vereinigung der flüssigen Lotoberflächen begonnen hat;

Fig.4 ein Beispiel für den zeitlichen Verlauf der Infrarot-Emission einer derartigen Lötstelle;

Fig.5 schematisch, teilweise in einem Blockschaltbild, eine Vorrichtung zum Laserlöten;

Fig.6 in einem Blockschaltbild einen Teil einer solchen Laserlöt-Vorrichtung, mit Lötstellen-spezifischer, umschaltbarer Signalauswertung;

Fig.7 ein Beispiel für den Verlauf eines Infrarot-Meßsignals (Signalamplitude) nach Glättung des Signals;

Fig.8 den Verlauf eines differenzierten derartigen Infrarot-Meßsignals, um die Änderung im Signalanstieg erkennbar zu machen;

Fig.9 das Ausgangssignal eines Komparators, dem das differenzierte IR-Meßsignal gemäß Fig. 8 zugeführt wird; und

Fig.10 ein Zeitdiagramm zur Veranschaulichung des Vorganges zur Erkennung der Benetzung.

Im folgenden sollen vorweg zur Erleichterung des Verständnisses die unterschiedlichen Phasen eines Lötprozesses im einzelnen erläutert werden, wobei einleitend verschiedene Begriffe, wie sie nachstehend in der Beschreibung verwendet werden, hinsichtlich der dabei jeweils gegebenen Möglichkeiten erläutert werden sollen.

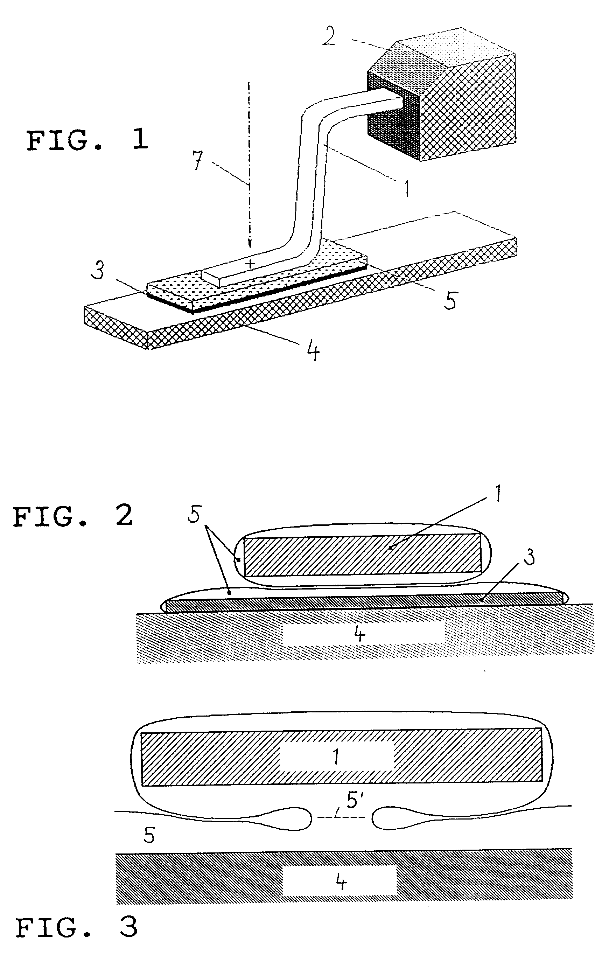

Üblicherweise ist, vgl. auch Fig.1, ein Bauteilanschluß an einer Lötfläche auf einer Leiterplatte anzulöten. Ein solcher Bauteilanschluß, im folgenden als "Lead" bezeichnet, ist in Fig.1 bei 1 ersichtlich und er steht von einem elektronischen Bauteil 2 (bzw. genauer dem Bauteilkörper oder -gehäuse) ab, beispielsweise unter Vorsehen einer doppelten Abwinkelung, wie in Fig.1 gezeigt. Ein solches Lead 1 besteht häufig aus Kupfer oder aus einer Eisen/Nickel-Legierung, und es ist beispielsweise einige Mikrometer dick entweder galvanisch oder durch Tauchen vorverzinnt.

Der Bauteil 2 ist mit seinem Lead 1 an einer zugehörigen Lötfläche 3 auf einer Leiterplatte 4 anzulöten, wozu die Lötfläche 3, im folgenden "Pad" bezeichnet, z.B. mit einer Lotschicht 5 versehen ist. Während das Pad 3 im Fall der Leiterplattentechnik beispielsweise aus Kupfer oder einer kupferhältigen Legierung besteht, so sei doch darauf hingewiesen, daß hier alle Metallisierungsarten, die bei gedruckten Schaltungen vorkommen, umfaßt sein sollen, wobei insbesondere auch andere Substrate anstatt herkömmliche Leiterplatten 4, etwa bei Dickschichthybridtechniken oder Dünnschichttechniken, möglich sind.

Die Lotschicht 5 kann beispielsweise heiß oder galvanisch aufgebracht worden sein, es ist aber auch denkbar, vor allem zusätzliches Lot in Pastenform aufzubringen. In letzterem Fall kann der Bauteilanschluß 1 in die nicht-getrocknete frische Lotpaste eingesetzt werden, wobei überdies auch ein Bauteilanschluß ohne Vorverzinnung bzw. Vorbelotung verwendbar ist.

Zur allgemeinen Einführung sei weiter erwähnt, daß beim Laserstrahllöten Prozeßparameter individuell an verschiedenartige Lötstellen angepaßt werden können. Ein Vorteil des Laserstrahllötens ist dabei bekanntlich, daß aufgrund der kurzen, intensiven Wärmeeinwirkung durch den Laserstrahl eine hervorragende Qualität der Lötverbindung erzielt werden kann. Es hat sich jedoch gezeigt, daß sich bei Vorgabe von zuvor empirisch ermittelten "optimalen" Bearbeitungsparametern bei gleichartigen Lötstellen häufig deutliche Abweichungen der sich einstellenden Löttemperatur ergeben, was in der Folge zu be-trächtlichen Streuungen in der Qualität dieser Lötstellen - trotz gleichbleibender zugeführter Wärmemenge - führen kann. So haben Versuche gezeigt, daß bei Bauteilen mit derselben Bauform für einen optimalen Lötvorgang die Notwendigkeit auftreten kann, unterschiedliche Laserstrahlleistungen bei gleicher Bestrahlungsdauer oder aber unterschiedliche Bestrahlungsdauern bei gleicher Laserstrahlleistung vorzusehen. Ohne derartige Anpassungen kann es hingegen dazu kommen, daß bei ein und demselben Lötstellentyp im einen Fall das Lot nicht zurfriedenstellend aufgeschmolzen wird oder keine zufriedenstellende Benetzung erfolgt, im anderen Fall das Basismaterial im Lötstellenbereich sogar thermisch beschädigt wird. In der Vergangenheit hat man nun versucht, einen temperaturgeregelten Laserstrahl-Lötprozeß insofern vorzusehen, als die Lötstellentemperatur überwacht wurde, wobei bei Feststellen des Aufschmelzens des Lots nach einer gewissen Zeitdauer, die insbesondere einstellbar sein sollte, der Erhitzungsvorgang beendet wurde. Untersuchungen haben jedoch gezeigt, daß einerseits bei schnellen Laserlötprozessen der Zeitpunkt des Aufschmelzens des Lots im aufgenommenen IR-Meßsignal kaum mehr erkennbar ist, und daß andererseits aufgrund der Streuungen beispielsweise bei den Materialien der zu lötenden Bauelemente die erforderliche Zeitdauer ab Beginn des Aufschmelzens des Lots bis zu dem Zeitpunkt, wo eine Benetzung der zu verlötenden Teile angenommen werden kann, viel zu stark variiert. Demgemäß führte die bekannte Technik zu einer hohen Anzahl von unzureichenden Lötstellenqualitäten, abgesehen davon, daß sie sich nur für langsame Lötprozesse eignete.

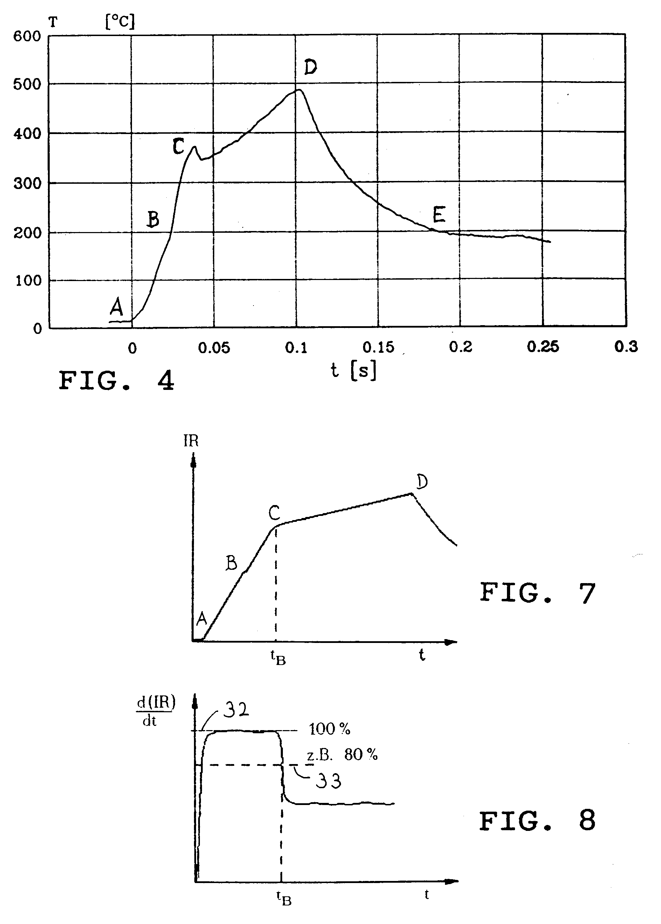

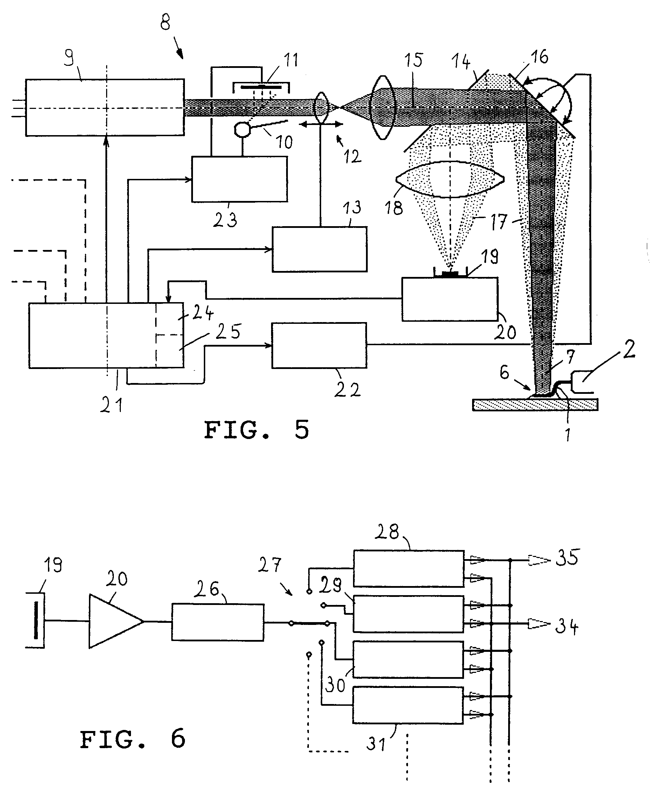

Gemäß Fig.1 bis 4 wird beim Löten der Lötstelle (6 in Fig.5) durch den Laserstrahl 7 (Fig.1; Fig.5) lokal Wärme zugeführt (ab Punkt A in Fig.4). Dabei liegt zu Beginn noch ein schlechter Wärmekontakt zwischen dem Lead 1 und dem Pad 3 vor - es existiert noch keine metallische Wärmeleitung zwischen dem Lead 1 und dem Pad 3. In dieser Phase wird die Laserleistung - vor allem aus geometrischen Gründen - hauptsächlich vom Lead 1 absorbiert, was zu einer raschen Erwärmung desselben führt. Wegen des noch schlechten Wärmeübergangs geht die Erwärmung des Pads 3 hingegen viel langsamer vor sich. Da die Temperaturzunahme im Lead 1 gegenüber jener im Pad 3 vorauseilt, schmilzt zuerst leadseitig das Lot 5 auf, und es benetzt dieses. In der Folge schmilzt auch das Lot 5 auf dem Pad 3. Diese Situation ist in Fig.2 dargestellt. Bemerkenswert ist hierbei, daß für eine Zeitdauer zwei Flüssigkeitsoberflächen miteinander in Berührung stehen können, ohne sich zu vereinigen, wie dies in Fig.2 dargestellt ist.

Sofern ein Pad 3 ohne Lotbeschichtung verwendet wird, vielmehr nur ein mit Lot 5 versehenes Lead 1 zur Anwendung kommt, liegt das geschmolzene Lot 5 kurze Zeit als flacher Tropfen auf der blanken Oberfläche des Pads 3, ohne diese Oberfläche zu benetzen, obwohl auch diese Oberfläche bereits die Schmelztemperatur des Lotes 5 überschritten haben kann.

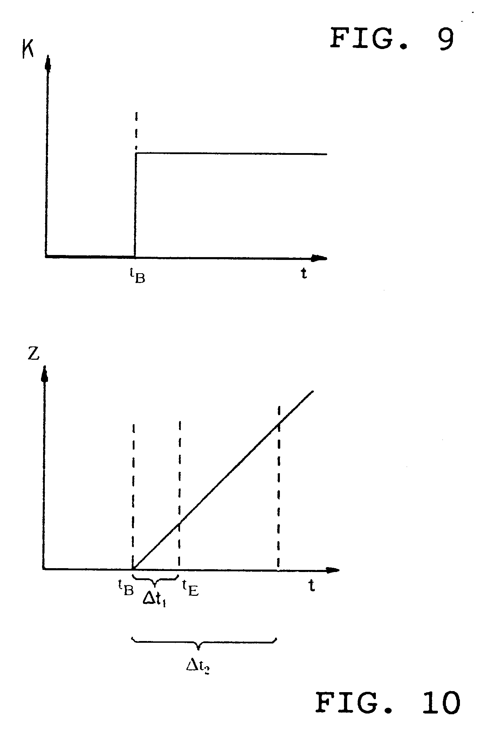

Daß die Vereinigung der Flüssigkeitsoberflächen bzw. die Benetzung der Festkörperoberfläche noch nicht eingesetzt hat, äußert sich darin, daß die Lead-Temperatur auch unmittelbar nach Erreichen des Schmelzpunktes des Lots 5 nahezu gleichbleibend ansteigt. Erst verzögert gegenüber jenem Zeitpunkt, in dem das Pad 3 den Lotschmelzpunkt erreicht, beginnt zunächst lokal die Vereinigung der Flüssigkeitsoberflächen bzw. der Benetzungsvorgang. Diese Situation ist in Fig.3 dargestellt. Dieser energetisch sehr ungünstige Zustand, in dem die gemeinsame Flüssigkeitsoberfläche sehr starke Krümmungen aufweist, führt rasch zu einem neuen Gleichgewicht, d.h. die "gemeinsame" Fläche (die in Fig.3 schematisch bei 5' angedeutet ist) wird sich sehr rasch vergrößern. Dieser Vorgang ist mit einer nahezu sprunghaften Verbesserung des Wärmeübergangs zwischen dem Lead 1 und dem Pad 3 verbunden. Durch die sprunghafte Verbesserung des Wärmeüberganges wird plötzlich ein wesentlich größerer Teil der zugeführten Wärme in das Pad 3 bzw. in das Basismaterial 4 abgeleitet. Dadurch kann die Lead-Temperatur trotz fortgesetzter Wärmezufuhr durch den Laserstrahl 7 sogar kurz absinken, bevor sie neuerlich ansteigt (wie dies auch bei C in Fig.4 ersichtlich ist). Jedenfalls geht die weitere Erwärmung des Leads 1 ab diesem Zeitpunkt deutlich langsamer vor sich als in der oben beschriebenen ersten Erwärmungsphase, d.h. es ist ein ausgeprägter Knick im zeitlichen Verlauf festzustellen, s. außer Fig.4 auch Fig.7.

Die Tatsache, daß zwischen dem Erreichen der Schmelztemperatur des Lotes 5 am Pad 3 (Punkt B in Fig. 4) und dem Einsetzen der Benetzung (Punkt C in Fig. 4) Zeit vergeht, ist umso mehr von Bedeutung, je rascher die Wärme zugeführt wird, d.h. je höher die Laserleistung ist. Im Rahmen experimenteller Untersuchungen wurde beobachtet, daß beim Löten gleichartiger Lötstellen die Differenz zwischen dem Schmelzpunkt und jener Temperatur, bei der die Benetzung einsetzt (Benetzungstemperatur), mit steigender Laserleistung zunimmt. So zeigte sich, daß die Benetzungstemperatur bei entsprechend hoher Laserleistung um mehr als 100°C über dem Lotschmelzpunkt liegen kann, wobei die Zeit zum Durchlaufen dieser Temperaturdifferenz nur wenige Millisekunden beträgt. Je geringer die Laserleistung ist, umso kleiner ist dieser Temperaturunterschied, wobei die Zeitspanne zwischen dem Erreichen des Schmelzpunktes am Benetzungsbeginn größer wird. Wenn die Oberflächentemperatur den Schmelzpunkt um nur wenige Grade überschreitet, so kann diese Zeitspanne (selbst bei optimaler Benetzbarkeit) bereits einige hundert Millisekunden betragen.

Dies verdeutlicht aber, daß der Benetzungsprozeß und das Aufschmelzen des Lotes zwei grundverschiedene Vorgänge sind: die Benetzung setzt lediglich das Aufschmelzen voraus. Anders ausgedrückt heißt das: Das Erreichen des Lotschmelzpunktes ist zwar ein notwendiges, aber kein hinreichendes Kriterium für den Benetzungsvorgang.

Nach Abschalten der Wärmezufuhr durch den Laserstrahl (bei D in Fig.4) sind hohe Abkühlgeschwindigkeiten bis zu einigen Tausend Grad pro Sekunde beobachtbar, die auf eine gute Wärmeableitung in die nicht miterwärmte Umgebung der Lötstelle zurückzuführen sind. Trotz dieser dynamischen Abkühlung kann bei Loten aus reinem Zinn oder eutektischer Zusammensetzung das Erstarren anhand einer deutlichen Verminderung der Abkühlgeschwindigkeit beim Erreichen des Schmelzpunktes (E in Fig.4) erkannt werden. Danach sinkt die Temperatur weiterhin schnell ab (einige hundert Grad pro Sekunde), so daß der für Rekristallisationsprozesse und Diffusionsvorgänge bedeutsame Temperaturbereich rasch durchlaufen wird. Dies ist der Grund für die an sich bekannte feine Gefügeausbildung und die höhere Festigkeit lasergelöteter Verbindungen.

Bisherige Systeme gehen wie erwähnt von der Überwachung der Lötstellentemperatur aus. Ziel ist es hierbei, das Aufschmelzen des Lotes zu erkennen. Eine berührungslose Temperaturmessung basiert jedenfalls auf einer Infrarot-(IR)-Strahlungsmessung, wobei ein Teil der vom interessierenden Körper ausgehenden Wärmestrahlungsleistung auf einem IR-Detektor einfällt, der ein elektrisches Signal als Maß für diese Strahlungsleistung liefert. Da die von einem Körper emittierte IR-Strahlung jedoch nicht lediglich von seiner Oberflächentemperatur abhängt, sondern auch von Emissionsgrad und Oberflächengröße, und die IR-Strahlung richtungsabhängig ist, so daß unterschiedliche Oberflächenteile einer Lötstelle 6 (Fig.5) selbst bei gleicher Temperatur unterschiedliche Beiträge zum Meßsignal liefern, ist eine unmittelbare Zuordnung von Temperatur und IR-Detektorsignal erst nach Kalibrieren des Meßsystems für die jeweilige Lötstelle möglich. Hiefür kann beispielsweise die Schmelzenthalpie des Lotes ausgenützt werden, die bei hinreichend langsamer Erwärmung und bei hinreichend kleinem Schmelzintervall des Lotes zu einer auswertbaren Verminderung des Temperaturanstieges führt.

Ein anderes Verfahren beruht auf der Messung der Schallausbreitung, die sich beim Aufschmelzen des Lotes signifikant verschlechtert.

In jedem Fall wird bei diesen bekannten Systemen nach dem Erreichen des Schmelzpunktes Ausschau gehalten. Für die Überwachung des Lötprozesses ist hingegen - nach den der Erfindung zugrundeliegenden Erkenntnissen - das Detektieren des sich sprunghaft verändernden Wärmeübergangs zwischen dem Lead 1 und dem Pad 3 besser geeignet, da

- die beobachtete Veränderung auf den Benetzungsvorgang zurückzuführen ist und dieser ein unmittelbareres Kriterium für den Lötprozeß darstellt als bloß das Aufschmelzen des Lotes und
- keine Temperaturmessung erforderlich ist, sondern mit einem nicht kalibrierten Wärmestrahlungsmeßsystem das Auslangen gefunden werden kann.

Darüber hinaus kann bei diesem Überwachungsprinzip der Vorteil der kurzen Wärmeeinwirkzeiten, die das Laserlöten ermöglicht, besser ausgenützt werden. So läßt sich beispielsweise eine hervorragende Qualität von Lötstellen mit einer Strahleinwirkdauer von nur 100 ms (oder auch nur 10 ms, bei kleinen Lötstellen) erzielen. Der Aufheizvorgang ist hier so dynamisch, daß sich kein signifikanter Temperaturhaltepunkt beim Aufschmelzen beobachten läßt, und zwar auch dann nicht, wenn direkte Temperaturmessungen mit einem an der Lötstelle angeordneten Thermoelement vorgenommen werden. Der bei einer wesentlich höheren Temperatur einsetzende Benetzungsvorgang hingegen verursacht selbst bei diesen Aufheizraten eine charakteristische Änderung der Signalverläufe, Fig.4.

Anhand der Fig.5 soll nun eine bevorzugt eingesetzte Vorrichtung zum Laserlöten beschrieben werden. Dabei sei voraus-geschickt, daß bei einem Großteil von elektronischen Bauteilen 2 (oberflächenmontierten Bauteilen) die Anschlüsse symmetrisch angeordnet sind; es ist daher sinnvoll, mit zwei voneinander unabhängigen Laserstrahlen 7 gleichzeitig an einem derartigen Bauteil 2 zu löten, und hierfür wird zweckmäßigerweise eine Anlage mit zwei gleichartig aufgebauten optischen Systemen (Strahlablenkung, Strahlfokussierung und Regelung der Laserstrahlparameter) vorgesehen. In Fig.5 ist jedoch nur ein einfaches derartiges System veranschaulicht, wobei gegebenenfalls ein zweites derartiges System, das völlig analog dazu aufgebaut wäre, mit vorgesehen werden könnte.

Aus Fig.5 ist eine Lasereinrichtung 8 mit einem Dauerstrichlaser 9, beispielsweise einem Nd-YAG-Laser, ersichtlich, welchem ein Spiegel-Shutter 10 zugeordnet ist. Zweckmäßigerweise wird ein Dauerstrichlaser 9 mit schnell steuerbarer Laserleistung eingesetzt. Der Laserstrahl wird über den Spiegel-Shutter 10 in den Zeiten, in denen keine Wärmezufuhr benötigt wird (Positioniervorgänge zwischen zwei Bauteilen 2 etc.), in einen Laserleistungsmesser 11 abgelenkt. Für die Dauer der Wärmezufuhr gibt der Spiegel-Shutter 10 den Laserstrahl 7 frei. Der Laserstrahl 7 wird durch eine Arbeitsoptik 12 fokussiert, deren Brennweite über eine Brennweitensteuerung 13 in an sich bekannter Weise numerisch steuerbar ist. Hinter dieser Arbeitsoptik 12 befindet sich ein Infrarot-Auskoppelspiegel 14, im vorliegenden Fall in Form eines "Lochspiegels", jedoch könnte auch ein vollflächiger Spiegel mit spezieller dielektrischer Beschichtung eingesetzt werden; dieser Auskoppelspiegel 14 ist im Winkel von 45° zur optischen Achse 15 angeordnet und verändert den Laserstrahl 7 nicht. Der Laserstrahl 7 wird schließlich über ein zweiachsiges Spiegelablenksystem mit X- und Y-Galvospiegel 16 auf die Lötstelle 6 gerichtet. Die Lötstelle 6 wird im Betrieb vom Laserstrahl 7 erwärmt und sendet infrarote Wärmestrahlung aus. Ein Teil dieser IR-Strahlung, wobei der Raumwinkel durch die Apertur des optischen Systems gegeben ist, wird - wie in Fig.5 bei 17 ersichtlich ist - über die Galvospiegel 16 eingefangen und in die optische Achse 15 zurück zum Laser 9 gerichtet. Durch den Infrarot-Auskoppelspiegel 14 wird ein Großteil dieser Wärmestrahlung 17 auf eine Infrarot-Optik 18 gelenkt, die die Lötstelle 6 auf einem Infrarot-Strahlungssensor order -detektor 19 abbildet. Die IR-Optik 18 - vorzugsweise eine Germaniumlinse, bei Verwendung eines Nd-YAG-Lasers - hat im wesentlichen zwei Aufgaben zu erfüllen: Sie muß erstens die von der Lötstelle 6 reflektierte Laserstrahlung, z.B. hier mit der Wellenlänge von 1,06 $\mu$m, ausfiltern, um eine Beschädigung des hochsensiblen IR- Detekors 19 zu verhindern bzw. das Meßsignal nicht zu verfälschen, und sie muß zweitens die Lötstelle 6 so auf der aktiven Detektorfläche abbilden, daß eine möglichst punktförmige Messung erfolgen kann.

Dem IR-Detektor 19 ist ein Meßverstärker 20 von an sich herkömmlicher Bauart zugeordnet, an dessen Ausgang eine zentrale Steuereinheit 21 angeschlossen ist. Diese zentrale Steuereinheit 21 bewirkt programmgesteuert die vorstehend genannten Funktionen, wobei die geometrischen Daten (Koordinaten) der Lötstellen 6 (bzw. der Bauteile 2) von einem CAD-bzw. CAM-System übernommen werden können.

Die beschriebene Vorrichtung ermöglicht ein kontinuierliches Abarbeiten der Lötstellen, wobei nicht nur der Laser 9 und das Wärmestrahlungsmeßsystem 19, 20 sillstehen, sondern auch das Werkstück (Lötstellen 6) unbeweglich bleibt. Die einzigen bewegten Teile sind die trägheitsarmen X-/Y-Galvospiegel 16. Im Gegensatz zu Laserlötanlagen, bei denen das Werkstück (oder die Arbeitsoptik inklusive IR-Sensor) bewegt wird und somit ein erheblicher Zeitanteil auf Positioniervorgänge entfällt, spielt bei der vorliegenden Vorrichtung die Positionierzeit nur eine untergeordnete Rolle. Die X-/Y-Galvospiegel 16 werden dabei über eine elektronische Galvospiegelsteuerung 22 von der zentralen Steuereinheit 21 angesteuert, ähnlich wie von letzterer auch der Spiegel-Shutter 10 über eine Spiegelshutter-Steuerung 23 angesteuert wird.

Wie erwähnt verursachen insbesondere Toleranzen bei der Bauteilfertigung und bei der Herstellung gedruckter Schaltungen Schwankungen einerseits im Wärmebedarf und andererseits in den optischen Eigenschaften, die für die absorbierte Laserleistung ausschlaggebend sind. Um diese Schwankungen ausgleichen zu können, wird der Fortgang des Lötprozesses mit Hilfe der von der Lötstelle 6 emittierten Wärmestrahlung 17 (IR-Signal) überwacht. Darüber hinaus ist auch eine Prozeßkontrolle insofern von Interesse, als die Qualität der entstandenen Lötverbindung erkannt und darüber ein Protokoll angefertigt werden kann. In jedem Fall wird dabei nach dem Einsetzen des Benetzungsvorganges Ausschau gehalten, indem die Änderung des IR-Signalanstieges ausgewertet wird, wie nachstehend anhand insbesondere der Fig.7 und 8 erläutert werden wird.

Die Verschiedenartigkeit der Lötstellen 6 und ihrer thermischen Eigenschaften ist jedoch mit einer großen Varianz von Signalverläufen verbunden, so daß das Auffinden des gesuchten Kriteriums entweder eine Methode mit sehr hoher Flexibilität erfordert oder eine Anzahl von Einzelmethoden, von denen jeweils eine für eine spezielle Lötstellentype geeignet ist.

Der erste Weg kann vorteilhafter Weise durch digitale Signalverarbeitung software-technisch beschritten werden, wobei aber mit steigender Flexibilität auch die Komplexität des Programms steigt und die Geschwindigkeit sinkt - man kann in der kurzen zur Verfügung stehenden Zeit (im ms-Bereich) nur eine beschränkte Anzahl von Rechenoperationen durchführen.

Der zweite Weg kann schaltungstechnisch z.B. durch Kombination von Analogsignalbausteinen, wie Differenzier- und Integrierglieder, Komparatoren etc., realisiert werden, wobei in Fig.5 schematisch eine Detektionseinheit 24 (z.B. mit Differenzierer und Komparator) und ein Zähler 25 veranschaulicht sind. Man setzt also jeweils einen einfachen Analogrechner mit einem fixen Rechengang ein. Diese Methode der Signalerkennung ist in der Geschwindigkeit nicht übertreffbar, der Rechengang läßt sich jedoch praktisch nur jeweils für eine Lötstellenart optimieren. Das Steuerprogramm wählt dann jeweils den passenden "Analogrechner" aus. In Fig.6 ist eine solche Ausführungsform mit mehreren dem IR-Detektor 19 samt Meßverstärker 20 sowie einer Signalglättungseinheit 26 über eine Schalteinheit 27 nachgeschalteten, Lötstellen-spezifischen Signalaufbereitungs-und auswerteinheiten 28, 29, 30, 31 (entsprechend der Detektionseinheit 24 in Fig.5) veranschaulicht, wobei die Auswahl - d.h. die Erkennungs-Betriebsartenwahl je nach Lötstellentyp - mittels der Schalteinheit 27 z.B. durch ein Steuerprogramm, durch die Steuereinheit 21, erfolgen kann.

Zwischen den beiden vorstehenden Wegen der IR-Signalverarbeitung ist jede beliebige Kombination denkbar: Beispielsweise kann für jene Lötstellentypen das IR-Signal auf analogem Weg verarbeitet werden, wo eine betriebssichere Erkennung mit wenig Schaltungsaufwand erzielt wird (bzw. aufgrund geringer thermischer Massen nur wenig Zeit zum Erkennen aufgewendet werden darf), und kann für die verbleibenden Lötstellenarten das A/D-gewandelte Signal einem oder mehreren Prozessen zugeführt werden.

Die grundlegende Idee für die Prozeßkontrolle ist jedoch bei allen Lötstellentypen dieselbe. Sie soll im folgenden anhand eines Beispiels noch näher erläutert werden.

In Fig.7 ist die Amplitude des gemessenen Infrarot-Signals IR (IR-Meßsignal) über der Zeit aufgetragen. Dabei handelt es sich um das IR-Meßsignal nach der Glättung, also am Ausgang der Signalglättungs-Einheit 27 gemäß Fig.6. Auch im Diagramm von Fig.7 sind die Punkte A (Beginn des Erhitzungsvorganges mittels Laserstrahl), B (Beginn des Aufschmelzens des Lots), C (Beginn des Benetzungsvorganges, beim Zeitpunkt $t_B$ Knick in der Kurve) und D (Beendigung des Erhitzungsvorganges), ähnlich wie in Fig. 4, veranschaulicht.

Aus dem IR-Meßsignal IR gemäß Fig.7 wird durch Differentiation der jeweilige Signalanstieg ermittelt, vgl. Fig.8. Wie auch aus dieser Fig.8 ersichtlich, ist vor dem Benetzungszeitpunkt $t_B$ der Anstieg des IR-Signals größer als danach, entsprechend dem Knick ab dem Punkt C der Kurve in Fig.7. Dies ist besonders deutlich aus Fig.8 ersichtlich, wo das differenzierte IR-Signal, entsprechend dem Anstieg des IR-Meßsignals, zum Zeitpunkt $t_B$ stufenförmig abfällt. Bei 32 ist dabei der 100%-Pegel des differenzierten IR-Signals vorhanden, und bei 33 wird ein relativer Vergleichs- oder Komparatorpegel, z.B. bei 80% des maximalen (100%-)Pegels 32, festgelegt. Sofern zum Zeitpunkt $t_B$ der Pegel, d.h. das differenzierte IR-Signal, gemäß Fig.8, unter dem relativen Komparatorpegel, z.B. den 80%igen Vergleichspegel 33 gemäß Fig.8, fällt, erscheint am ensprechenden Ausgang der Vergleichseinheit (Komparator) der (jeweiligen) Detektionseinheit oder Auswerteinheit, z.B. 24 (Fig.5) bzw. 28, 29, 30 oder 31 (Fig.6), ein Signal K, vgl. Fig.9.

Da für Lötstellen 6 desselben Typs die Steigungen der Signale Streuungen unterworfen sind, wird der vorstehend angegebene relative Komparatorpegel (z.B. wie erwähnt 80%) angewandt, mit dem der weitere Signalverlauf verglichen wird. Sinkt der Anstieg der Signalamplitude in Fig.7 unter diesen Vergleichspegel 33 (Fig.8), so schaltet der Komparator (Fig.9), und er startet einen Zeitzähler (Zähler 25 in Fig.5). Gleichzeitig kann der IR-Pegel gemäß Fig.7 abgespeichert werden.

Schaltet die Vergleichseinheit (der Komparator) nun bereits nach einer kurzen Zeitspanne zurück, da der IR-Signalanstieg nur einen kurzen Einbruch hatte (das könnte bei nicht allzu schnellen Lötvorgängen während des Aufschmelzens des Lots durch die Schmelzwärme passieren), so wird der Zähler 25 gestoppt und auf Null gesetzt. Wird hingegen ein vorgegebenes Zeitintervall $\Delta t_1$ (s. Fig.10) überschritten, so wird im Augenblick tE erkannt, daß der Zeitpunkt $t_B$ der Benutzungsbeginn war: $t_E - \Delta t_1 = t_B$, vgl. Fig. 10, in der der Zählerstand Z über der Zeit t aufgetragen ist.

Vom Zeitpunkt $t_B$ ausgehend kann nun entweder eine Erhöhung des IR-Signalpegels um einen vorwählbaren Betrag (z.B. 30% des IR-Pegels zum Zeitpunkt $t_B$) oder eine bestimmte Zeitspanne $\Delta t_2$ abgewartet werden, bis die Wärmezufuhr durch den Laserstrahl 7 abgeschaltet wird. (Ein Verändern der Laser-leistung wird im allgemeinen nur bei einem Wechsel des Lötstellentyps vorgesehen). Der Parameter $t_B$ bzw. die Zeit bis zum Erreichen des Signalpegeldifferenz (im obigen Beispiel 30%) bzw. die gemessene Pegeldifferenz bei vorgegebenem $\Delta t_2$ kann mit Erfahrungswerten verglichen werden, und je nach dem Ergebnis dieses Vergleichs kann die Lötstellenqualität beurteilt werden. Das Bewertungsergebnis (entweder einwandfrei" oder "suspekt") wird jeweils in einem Protokollspeicher abgespeichert. In Fig.6 ist bei 34 schematisch ein Ausgang zu einem (nicht näher dargestellten) Protokollspeicher veranschaulicht, wogegen bei 35 der Ausgang zu Lasersteuerung gezeigt ist.

Im Fall einer digitalen Signalverarbeitung können in der Parameterbibliothek z.B. folgende Informationen gespeichert werden:

- Lötstellentyp (Typ des Substrats 4, der Lötfläche 3, des Bauteils 2, des Bauteilanschlusses 1 etc.)
- Daten für die Auswahl einer bestimmten Art der Signalaufbereitung (entweder Analogschaltung, mit Wahl des "Analogrechners", oder Algorithmus) Lötstellen-spezifische Parameter, wie z.B. die (relative) Höhe des Komparatorpegels 33; $\Delta t_1$; $\Delta t_2$; Signalpegeldifferenz, die bis zum Abschalten der Wärmezufuhr abgewartet wird;

Die Werte für die Zeitintervalle $\Delta t_1$, $\Delta t_2$ bzw. für die Signalpegeldifferenz werden empirisch ermittelt und sinnvollerweise in der Parameterbibliothek abgespeichert. Es wird daher aus praktischen Gründen (leichtere Anpassung an veränderte Lötstelleneigenschaften ("Teach-in"-Prozeß etc.) eine rein software-technische Signalerkennung angestrebt, jedoch ist - z.B. im Hinblick auf die erwähnten Geschwindigkeitsvorteile - die analoge Methode vielfach vorzuziehen.

Beispielsweise kann im Fall eines oberflächenmontierten Bauteils, dessen Anschlußbeinchen 1 auf einem Kupfer-Pad 3 festzulöten ist, bei Verwendung eines Dauerstrichlasers 9 mit einer Leistung von ca. 20 W das Zeitintervall $\Delta t_1$ mit ungefähr 20 ms und das Zeitintervall $\Delta t_2$ mit ungefähr 60 ms festgelegt werden. Der Zeitpunkt $t_B$ (Punkt C in Fig.4) liegt bei annähernd 40 ms ab Beginn des Lötvorganges (Punkt A in Fig.4). Die gesamte Lötzeit pro Lötstelle 6 beträgt dann ungefähr 100 ms. Während die Aufschmelztemperatur (Punkt B in Fig.4) bei ungefähr 200°C nach ungefähr 25 ms erreicht wird, wobei dieser Punkt infolge der hohen Lötgeschwindigkeit kaum als signifikanter Punkt auftritt und daher nicht feststellbar ist (vgl. die Kurven in Fig.4 sowie in Fig.7), ist die Veränderung im Anstieg der Meßkurve (Fig.7), vergleichbar dem Temperaturverlauf gemäß Fig.4, beim Beginn des Benetzungsvorganges (Punkt C, bei $t_B$), nach ungefähr 40 ms, außerordentlich signifikant, und zwar auch bei den genannten hohen Lötgeschwindigkeiten, und von dieser beginnenden Benetzung weg kann durch einige wenige vorhergehende Versuche problemlos das Zeitintervall $\Delta t_2$ als Maß für die vollständige Benetzung der zu verlötenden Teile bzw. der Vereinigung der Lot-Flüssigkeiten in Erfahrung gebracht werden.

## Patentansprüche

1. Verfahren zum Löten, bei dem ein auf wenigstens einem Werkstück vorhandenes Lot (5) mittels eines Laserstrahls (7) erhitzt und die von der Lötstelle abgegebene Wärmestrahlung (17) erfaßt wird, um die Erhitzung mittels des Laserstrahls (7) nach dem Aufschmelzen des Lots zu beenden, dadurch gekennzeichnet, daß die erfaßte Wärmestrahlung (17) auf eine nach dem Aufschmelzen des Lots auftretende, eine Benetzung (C) der zu lötenden Teile (1, 3) repräsentierende Unstetigkeit im Anstieg überwacht und erst nach der so erfolgten Feststellung der Benetzung die Erhitzung mittels des Laserstrahls (7) beendet wird.

2. Verfahren nach Anspruch 1, dadurch gekennzeichnet, daß ein der erfaßten Wärmestrahlung (17) entsprechendes Infrarot-Meßsignal auf eine andauernde verminderte Steigung im zeitlichen Signalverlauf überwacht wird.

3. Verfahren nach Anspruch 2, dadurch gekennzeichnet, daß das Infrarot-Meßsignal nach der Zeit differenziert wird und der Pegel der so erhaltenen ersten Ableitung des Infrarot-Meßsignals mit einem vorherbestimmten Schwellenwert (33) verglichen wird.

4. Verfahren nach Anspruch 3, dadurch gekennzeichnet, daß der Schwellenwert (33) als relativer Vergleichspegel, bezogen auf den Maximal-Pegel der ersten Ableitung des Infrarot-Meßsignals vor dem Zeitpunkt ($t_B$) des Auftretens der verminderten Steigung, bestimmt wird.

5. Verfahren nach Anspruch 4, dadurch gekennzeichnet, daß der Vergleichspegel (33) bei 80% des Maximalpegels festgelegt wird.

6. Verfahren nach einem der Ansprüche 2 bis 5, dadurch gekennzeichnet, daß zur Feststellung einer eine Benetzung anzeigenden andauernden verminderten Steigung überwacht wird, ob die Dauer des Meßsignals mit verminderter Steigung ein vorherbestimmtes Zeitintvervall ($\Delta t_1$) überschreitet.

7. Verfahren nach Anspruch 6, dadurch gekennzeichnet, daß das Infrarot-Meßsignal nach Festellen einer andauernden verminderten Steigung auf eine Erhöhung des Signalpegels um einen vorherbestimmten Betrag gegenüber dem Pegel zu Beginn (C) der verminderten Steigung überwacht und erst dann der Erhitzungsvorgang beendet wird.

8. Verfahren nach Anspruch 7, dadurch gekennzeichnet, daß auf eine Erhöhung des Pegels des Infrarot-Meßsignals um ungefähr 30% überwacht wird.

9. Verfahren nach Anspruch 7 oder 8, dadurch gekennzeichnet, daß die Zeit bis zum Erreichen des erhöhten Signalpegels gemessen und zur Beurteilung der Lötstellenqualität mit vorgegebenen Zeitintervallwerten verglichen wird.

10. Verfahren nach Anspruch 6, dadurch gekennzeichnet, daß nach Feststellen einer andauernden verminderten Steigung der Erhitzungsvorgang ein vorherbestimmtes Zeitintervall ($\Delta t_2$) fortgesetzt wird, bevor er beendet wird.

11. Verfahren nach Anspruch 10, dadurch gekennzeichnet, daß die Erhöhung des Signalpegels des Infrarot-Meßsignals am Ende des vorherbestimmten Zeitintervalls ($\Delta t_2$) gegenüber dem Pegel am Beginn der andauernden verminderten Steigung gemessen und zur Beurteilung der Lötstellenqualität mit vorgegebenen Pegeldifferenzwerten verglichen wird.

12. Vorrichtung zur Durchführung des Verfahrens nach einem der Ansprüche 1 bis 11, mit einer Lasereinrichtung (8) zur Abgabe eines Laserstrahls (7), der auf eine Lötstelle (6) gerichtet wird, mit einem Infrarot-Detektor (19), dem die von der Lötstelle (6) abgegebene Wärmestrahlung (17) zugeführt wird, und mit einer an den Infrarot- Detektor (19) angeschlossenen Steuereinheit (21), die die Lasereinrichtung (8) abhängig vom Infrarot-Meßsignal des Infrarot-Detektors (19) sowie Relativbewegungen zwischen Werkstück und Laserstrahl (7) steuert, dadurch gekennzeichnet, daß die Steuereinheit (21) eine Detektionseinheit (24) zur Erkennung einer eine Benetzung (C) der zu lötenden Teile (1, 3) repräsentierende Unstetigkeit im Anstieg des Infrarot-Meßsignals enthält.

13. Vorrichtung nach Anspruch 12, dadurch gekennzeichnet, daß die Detektionseinheit (24) zwischen verschiedenen Erkennungs-Betriebsarten, entsprechend verschiedenen Lötstellen (6), umschaltbar ist.

14. Vorrichtung nach Anspruch 12 oder 13, dadurch gekennzeichnet, daß die Detektionseinheit (24) zumindest eine Differenziereinheit mit nachgeschalteter Vergleichseinheit zum Differenzieren des IR-Meßsignals und Vergleichen des Pegels des differenzierten Signals mit einem Vergleichspegel aufweist.

15. Vorrichtung nach einem der Ansprüche 12 bis 14, dadurch gekennzeichnet, daß die Steuereinheit (21) einen von der Detektionseinheit (24) aktivierbaren Zähler (25) zur Messung von Zeitintervallen ($\Delta t_1$, $\Delta t_2$) ab Beginn einer erkannten Unstetigkeit im Anstieg des IR-Meßsignals aufweist..

16. Vorrichtung nach einem der Ansprüche 12 bis 15, dadurch gekennzeichnet, daß an die Steuereinheit (21) eine Galvospiegelsteuerung (22) mit X- und Y-Galvospiegel (16) im Strahlengang des Laserstrahls (7) angeschlossen ist, um den Laserstrahl (7) gesteuert zu den verschiedenen Lötstellen (6) am stationären Werkstück zu positionieren.

17. Vorrichtung nach Anspruch 16, dadurch gekennzeichnet, daß die abgegebene Wärmestrahlung (17) über den X- und Y-Galvospiegel (16) und einen IR-Auskoppelspiegel (14) zum Auskoppeln der Wärmestrahlung (17) aus dem Strahlengang des Laserstrahls (7) sowie über ein Filterelement (18) zum IR-Detektor (19) gerichtet wird.

18. Vorrichtung nach Anspruch 17, dadurch gekennzeichnet, daß der IR-Auskoppelspiegel (14) ein Lochspiegel ist, der mit seiner das den Laserstrahl (7) durchlassenden Loch umgebenden Spiegelfläche die Wärmestrahlung (17) reflektiert.

19. Vorrichtung nach Anspruch 17 oder 18, dadurch gekennzeichnet, daß das Filterelement (18) durch eine Germaniumlinse gebildet ist.

20. Vorrichtung nach einem der Ansprüche 16 bis 19, dadurch gekennzeichnet, daß die Steuereinheit (21) mit einem der Lasereinrichtung (8) zugeordneten Spiegelshutter (10) im Strahlengang des Laserstrahls (7) verbunden ist, um diesen während der Positionier-Betätigung der X- und Y-Galvospiegels (16) abzuschirmen.

21. Vorrichtung nach Anspruch 20, dadurch gekennzeichnet, daß der Spiegelshutter (10) den Laserstrahl (7) während der Positionier-Betätigung des X- und Y-Galvospiegels (16) zu einem Laserleistungsmesser (11) ablenkt.

**Claims**

1. A method of soldering, in which a solder (5) present on at least one work piece is heated by means of a laser beam (7) and the heat radiation (17) from the soldering joint is sensed to terminate heating by means of the laser beam (7) when the solder has been melted, characterised in that the heat radiation (17) sensed is monitored for a non-uniformity in its increase occurring after the solder has melted and representing a wetting (C) of the parts (1, 3) to be soldered, and only after the wetting has been detected such, heating by means of the laser beam (7) is terminated.

2. A method according to claim 1, characterised in that a measured infrared signal corresponding to the heat radiation (17) sensed is monitored for a lasting reduced increase in the temporal course of the signal.

3. A method according to claim 2, characterised in that the measured infrared signal is differentiated with respect to the time, and that the level of the first derivative of the measured infrared signal thus obtained is compared to a predetermined threshold value (33).

4. A method according to claim 3, characterised in that the threshold value (33) is determined as a relative comparison level, related to the maximum level of the first derivative of the measured infrared signal before the time ($t_B$) of the occurrence of the reduced increase.

5. A method according to claim 4, characterised in that the comparison level (33) is fixed at 80% of the maximum level.

6. A method according to any one of claims 2 to 5, characterised in that for determining a lasting reduced increase indicative of a wetting it is monitored whether or not the duration of the measured signal with the reduced increase exceeds a predetermined time interval ($\Delta t_1$).

7. A method according to claim 6, characterised in that after detection of a lasting reduced increase, the measured infrared signal is monitored for a rise of the signal level by a pre-determined amount relative to the level at the onset (C) of the reduced increase, and only then the heating procedure is terminated.

8. A method according to claim 7, characterised in that it is monitored for an increase of the level of the measured infrared signal by approximately 30%.

9. A method according to claim 7 or 8, characterised in that the time required until the increased signal level has been reached is measured and is compared with given time interval values so as to judge the quality of the soldering joint.

10. A method according to claim 6, characterised in that after detection of a lasting reduced increase, heating is continued for a pre-determined time interval ($\Delta t_2$), before it is terminated.

11. A method according to claim 10, characterised in that the increase of the signal level of the measured infrared signal at the end of the pre-deterimed time interval ($\Delta t_2$) is measured relative to the level at the onset of the lasting reduced increase and is compared with given level difference values so as to judge the quality of the soldering joint.

12. An arrangement for carrying out the method according to any one of claims 1 to 11, comprising a laser device (8) for emitting a laser beam (7) which is directed to a soldering joint (6), an infrared detector (19) which is supplied with the heat radiation (17) from the soldering joint (6), and a control unit (21) connected to the infrared detector (19) and controlling the laser device (8) in dependence on the measured infrared signal of the infrared detector (19) as well as relative movements between work piece and laser beam (7), characterised in that the control unit (21) contains a detection unit (24) for detecting a non-uniformity in the increase of the measured infrared signal representing wetting (C) of the parts to be soldered (1, 3).

13. An arrangement according to claim 12, characterised in that the detection unit (24) is switchable between different detection modes, corresponding to different soldering joints (6).

14. An arrangement according to claim 12 or 13, characterised in that the detection unit (24) comprises at least one differentiating unit followed by a comparing unit for differentiation of the measured IR signal and for comparing the level of the differentiated signal with a comparison level.

15. An arrangement according to any one of claims 12 to 14, characterised in that the control unit (21) comprises a counter (25) activatable by the detection unit (24) for measuring time intervals ($\Delta t_1$, $\Delta t_2$) from the onset of a detected non-uniformity in the increase of the measured IR signal.

16. An arrangement according to any one of claims 12 to 15, characterised in that a galvo mirror control (22) comprising an X and Y galvo mirror (16) is connected in the radiation path of the laser beam (7) to controlledly position the laser beam (7) to the different soldering joints (6) on the stationary work piece.

17. An arrangement according to claim 16, characterised in that the heat radiation (17) is directed towards the IR detector (19) via the X and Y galvo mirror (16) and via an IR decoupling mirror (14) for decoupling the heat radiation (17) from the radiation path of the laser beam (7) as well as via a filter element (18).

18. An arrangement according to claim 17, characterised in that the IR decoupling mirror (14) is an apertured mirror which reflects the heat radiation (17) with its mirror surface surrounding the aperture that allows the laser beam (7) to pass therethrough.

19. An arrangement according to claim 17 or 18, characterised in that the filter element (18) is formed by a germanium lense.

20. An arrangement according to any one of claims 16 to 19, characterised in that the control unit (21) is connected with a mirror shutter (10) associated to the laser device (8) in the radiation path of the laser beam (7), so as to shield the latter during the positioning of the X and Y galvo mirror (16).

21. An arrangement according to claim 20, characterised in that the mirror shutter (10) deflects the laser beam (7) towards a laser output measuring device (11) during the positioning operation of the X and Y galvo mirror (16).

**Revendications**

1. Procédé de soudage, dans lequel on réchauffe au moyen d'un faisceau laser (7) la soudure (5) présente sur au moins une pièce à oeuvrer, et l'on capte le rayonnement thermique (17) émis depuis l'emplacement de soudure, afin de terminer le chauffage au moyen du faisceau laser (7) après la fusion de la soudure, caractérisé en ce que le rayonnement thermique capté (17) est surveillé dans sa croissance vis-à-vis d'une instabilité qui se produit après la fusion de la soudure et qui représente un mouillage (C) des parties à souder (1, 3) et en ce que l'on termine le chauffage au moyen du faisceau laser (7) uniquement après que la constatation du mouillage a ainsi eu lieu.

2. Procédé selon la revendication 1, caractérisé en ce que l'on surveille un signal de mesure infrarouge qui correspond au rayonnement thermique capté (17), vis-à-vis d'une croissance constamment réduite dans le déroulement de signal temporel.

**3.** Procédé selon la revendication 2, caractérisé en ce que le signal de mesure infrarouge est différencié dans le temps, et en ce que l'on compare le niveau de la première dérivée ainsi obtenue du signal de mesure infra-rouge avec une valeur de seuil prédéterminée (33).

**4.** Procédé selon la revendication 3, caractérisé en ce que la valeur de seuil (33) est déterminée comme un seuil de comparaison relatif, par rapport au niveau maximum de la première dérivée du signal de mesure infra-rouge avant l'instant ($t_B$) de l'apparition de la croissance réduite.

**5.** Procédé selon la revendication 4, caractérisé en ce que le niveau de comparaison (33) est établi à 80% du niveau maximum.

**6.** Procédé selon l'une des revendications 2 à 5, caractérisé en ce que, pour déterminer une croissance constamment réduite qui indique un mouillage, on surveille si la durée du signal de mesure à croissance réduite dépasse un intervalle temporel prédéterminé ($Dt_1$).

**7.** Procédé selon la revendication 6, caractérisé en ce que, après avoir constaté une croissance constamment réduite, le signal de mesure infra-rouge est surveillé vis-à-vis d'une augmentation du niveau du signal d'un montant prédéterminé par rapport au niveau au début (C) de la croissance réduite, et en ce que l'on termine uniquement alors l'opération de chauffage.

**8.** Procédé selon la revendication 7, caractérisé en ce que l'on surveille vis-à-vis d'une augmentation du niveau du signal de mesure infra-rouge d'environ 30%.

**9.** Procédé selon l'une ou l'autre des revendications 7 et 8, caractérisé en ce que l'on mesure le temps jusqu'à atteindre le niveau de signal augmenté, et en ce que l'on le compare à des valeurs d'intervalle de temps données pour juger de la qualité de l'emplacement de soudage.

**10.** Procédé selon la revendication 6, caractérisé en ce que, après avoir constaté une augmentation constamment réduite, on poursuit l'opération de chauffage pendant un intervalle de temps prédéterminé ($Dt_2$), avant de la terminer.

**11.** Procédé selon la revendication 10, caractérisé en ce que l'on mesure l'augmentation du niveau de signal de mesure infrarouge à la fin de l'intervalle de temps prédéterminé ($Dt_2$) par rapport au niveau au début de l'augmentation constamment réduite, et en ce qu'on la compare à des valeurs de différence de niveau données pour juger de la qualité de l'emplacement de soudage.

**12.** Appareil pour mettre en oeuvre le procédé selon l'une des revendications 1 à 11, comprenant un dispositif à laser (8) pour émettre un faisceau laser (7), qui est dirigé vers un emplacement de soudure (6), comprenant un détecteur à infra-rouge (19) auquel on amène le rayonnement thermique (17) émis par l'emplacement de soudure (6), et comprenant une unité de commande (21) raccordée au détecteur à infra-rouge (19), qui commande le dispositif à laser (8) en fonction du signal de mesure du détecteur à infra-rouge (19) et qui commande les déplacements relatifs entre la pièce à oeuvrer et le faisceau laser (7), caractérisé en ce que l'unité de commande (21) contient une unité de détection (24) pour reconnaître une instabilité dans la croissance du signal de mesure infrarouge, qui représente un mouillage (C) des pièces à souder (1, 3).

**13.** Appareil selon la revendication 12, caractérisé en ce que l'unité de détection (24) est susceptible d'être commutée entre différents modes de reconnaissance, en correspondance de différents emplacements de soudage (6).

**14.** Appareil selon l'une ou l'autre des revendications 12 et 13, caractérisé en ce que l'unité de détection (24) comprend au moins une unité de différenciation suivie d'une unité de comparaison, afin de différencier le signal de mesure infrarouge et de comparer le niveau du signal différencié avec un niveau de comparaison.

**15.** Appareil selon l'une des revendications 12 à 14, caractérisé en ce que l'unité de commande (21) comprend un compteur (25), susceptible d'être activé par l'unité de détection (24), pour mesurer des intervalles de temps ($Dt_1$, $Dt_2$) à partir du début d'une instabilité reconnue dans la croissance du signal de mesure infra-rouge.

**16.** Appareil selon l'une des revendications 12 à 15, caractérisé en ce qu'une commande à miroir galvanométrique (22) avec miroirs de galvanomètre en X et en Y (16) dans le trajet du faisceau laser (7) est raccordée à l'unité de commande (21), afin de positionner le faisceau laser (7) de manière commandée vers les différents emplacements de soudage (6) par rapport à la pièce à oeuvrer stationnaire.

**17.** Appareil selon la revendication 16, caractérisé en ce que le rayonnement thermique émis (17) est dirigé vers le détecteur à infra-rouge (17) par l'intermédiaire des miroirs de galvanomètre en X et en Y (16) et d'un miroir de découplage à infra-rouge (14) afin de découpler le rayonnement thermique (17) hors du trajet du faisceau laser (7), ainsi que par l'intermédiaire d'un élément de filtration (18).

18. Appareil selon la revendication 17, caractérisé en ce que le miroir de découplage à infra-rouge (14) est un miroir à trou, qui réfléchit le rayonnement thermique (17) au moyen de sa surface de miroir qui entoure le trou qui laisse passer le faisceau laser (7).

19. Appareil selon l'une ou l'autre des revendications 17 et 18, caractérisé en ce que l'élément de filtration (18) est formé par une lentille au germanium.

20. Appareil selon l'une des revendications 16 à 19, caractérisé en ce que l'unité de commande (21) est reliée à un obturateur à miroir (10) associé au dispositif à laser (8) dans le trajet du faisceau laser (7), afin de faire écran à celui-ci pendant l'actionnement de positionnement des miroirs de galvanomètre en X et en Y (16).

21. Appareil selon la revendication 20, caractérisé en ce que l'obturateur à miroir (10) dévie le faisceau laser (7) pendant l'actionnement de positionnement des miroirs de galvanomètre en X et en Y (16) vers un appareil de mesure de la puissance laser (11).

FIG. 1

FIG. 2

FIG. 3

FIG. 4

FIG. 7

FIG. 8

FIG. 5

FIG. 6

FIG. 9

FIG. 10